# EUROPÄISCHE PATENTANMELDUNG

(11) **EP 1 953 812 A1**
(43) Veröffentlichungstag der Anmeldung: **06.08.2008**
(21) Anmeldenummer: 07002058.1
(22) Anmeldetag: 31.01.2007
(51) Int. Cl.: H01L 21/683, G03F 7/00

(54) **Substratträger**

(71) Anmelder: PROFACTOR Produktionsforschungs GmbH, 4407 Steyr-Gleink (AT)
(72) Erfinder: Gusenbauer, Markus, DI, 4040 Linz (AT); Rittenschober, Thomas, DI, Mag., 4040 Linz (AT); Mühlberger, Michael, Matthias, DI, Dr., 4060 Leonding (AT); Schöftner, Rainer, DI, Dr., 4400 Steyr (AT)
(74) Vertreter: Ofner, Clemens

(57) **Zusammenfassung**

Die Erfindung beschreibt einen Substratträger umfassend eine Trägerlage und zumindest ein funktionales Element, wobei dass das funktionale Element als Antriebsmittel ausgebildet ist.

## Beschreibung

Die Erfindung betrifft einen Substratträger umfassend eine Trägerlage und zumindest ein funktionales Element, eine Vorrichtung zur Formung von Mikro- bzw. Nanostrukturen auf einem Substrat, umfassend zumindest einen Substratträger, ein flächenhaftes Substrat und einen Stempel, wobei zumindest auf einer Flachseite des flächenhaften Substrats ein Imprint-Material aufgetragen ist und das Substrat vom Substratträger derart gehalten wird, dass das Imprint-Material einer Wirkfläche des Stempels zugewandt ist, und wobei auf der Wirkfläche des Stempels ein mikro- bzw. nanostrukturiertes Abbild der in das Imprint-Material zu prägenden Struktur aufgebracht ist, und wo der Stempel in einer Verfahrvorrichtung gehalten ist. Weiters betrifft die Erfindung ein Imprint Lithographie Verfahren zur Formung von Mikro- bzw. Nanostrukturen auf einem Substrat.

Zur Herstellung strukturierter mikroelektronischer Bauteile sind aus dem Stand der Technik mehrere Verfahren bekannt. Ein gemeinsames Merkmal von optischen Lithographieverfahren ist, dass auf ein meist flächenhaftes Substrat, welches bevorzugt aus einem halbleitenden Material gebildet ist, eine Schicht eines photosensitiven Materials aufgebracht wird, die in weiteren Verfahrensschritten strukturiert wird. Eine lichtundurchlässige Maske wird so strukturiert, dass sie dem Abbild bzw. dem Negativbild der gewünschten Mikrostruktur entspricht. Diese Maske wird über der fotoaktiven Schicht angeordnet und durch Beleuchten mit Licht werden die von der Maske nicht abgedeckten Bereiche belichtet, wobei die erzielbare Auflösung von der Wellenlänge des Lichts abhängt. Daher setzt man bevorzugt UV-Licht ein, da dies eine kleinere Wellenlänge als sichtbares Licht hat. Abhängig vom photoaktiven Material lassen sich in einem nachfolgenden Entwicklungsvorgang die belichteten bzw. nicht belichteten Abschnitte der photoaktiven Schicht vom Substrat entfernen. Auf dem Substrat verbleibt die photoaktive Schicht in der gewünschten Struktur, die bereits das gewünschte Endprodukt sein kann, oder aber als Maskenschicht für einen folgenden Ätz- oder Abscheidevorgang dient.

Die erzielbare Feinheit der Strukturen ist durch die Wellenlänge des verwendeten Lichts begrenzt. Nanostrukturen mit Strukturen im Bereich einiger 10nm lassen sich mit fotolithografischen Verfahren nur mit äußerst hohem Aufwand herstellen, beispielsweise mit einem EUV-Lithographieverfahren (Extreme Ultra Violet).

Ein Verfahren mit dem sich derart feine Strukturen kostengünstig replizieren lassen, ist beispielsweise ein UV-basiertes Nanoimprint Lithografieverfahren (UV-NIL). Bei diesem Verfahren ist das auf das Substrat aufgebrachte Imprint-Material beispielsweise durch ein Polymer gebildet, das bei Beleuchtung mit UV-Licht aushärtet. Auf einem Stempel wird durch Nanostrukturierung (z.B. Elektronenstrahllithographie und reaktives Ionenätzen) ein Abbild der gewünschten Struktur aufgebracht. Dieser Stempel wird in das Polymer eingedrückt und das Polymer durch eine UV-Flutbelichtung ausgehärtet. Danach wird der Stempel vom Substrat abgehoben, wobei im Imprint-Material das Negativbild der Struktur des Stempels zurückbleibt. Der Vorteil dieses Verfahrens liegt unter anderem darin, dass durch die Nanostrukturierung des Stempels eine sehr hohe Auflösung erreichbar ist, und dass durch das Stempelverfahren die Struktur relativ einfach und schnell auf einer größeren Fläche geprägt werden kann. Für weitere Details zu UV-basierten Nanoimprint Lithografieverfahren wird der kundige Fachmann an dieser Stelle auf den Stand der Technik verwiesen.

Die Qualität der geprägten Struktur hängt unter anderem wesentlich von der Eindringtiefe des Stempels in das Polymer ab. Da weder das Substrat noch der Stempel absolut plane Flachseiten aufweisen, stellt das Sicherstellen eines gleichmäßigen Kontakts zwischen Polymer und Stempel beim Prägevorgang eine sehr große Herausforderung dar und ist mit einfachen Verfahren nicht möglich. Die Unebenheiten der Stempeloberfläche rühren klarerweise nicht von der aufgebrachte Mikro- bzw. Nanostruktur her, sondern sind, wie auch die Unebenheiten des Substrats, herstellungsbedingt. Auch durch den Imprintprozess selbst kann es zu einer Verformung der Stempelhalterung mit Stempel kommen, wenn diese in das Imprintmaterial gedrückt wird. Diese Verformung addiert sich zu den herstellungsbedingten Unebenheiten von Stempel und Substrat. Für weitere folgende Verfahrensschritte ist es jedoch wesentlich, dass die minimale Schichtdicke des Polymers über die gesamte geprägte Fläche möglichst gering ist, jedenfalls jedoch möglichst konstant ist. Durch die Unebenheiten der Flachseiten von Stempel und Substrat wird es jedoch Abschnitte geben, wo kaum Polymer vorhanden ist und weiters wird es Abschnitte geben, wo noch eine beachtliche Restdicke vorhanden ist. Beispielsweise sind für einen nachfolgenden Ätzprozess diese unterschiedlichen Dicken von bedeutendem Nachteil, da der Ätzvorgang auch das Imprint-Material abträgt und daher in den Abschnitten mit einer dünnen verbliebenen Schichtdicke des Imprint-Materials bereits Substrat abgetragen wird, während in anderen Abschnitten noch das Imprint-Material abgetragen wird. Man erhält daher einen ungleichmäßigen Materialabtrag des Substrats, was insbesondere die Funktion des herzustellenden Bauteils wesentlich beeinträchtigen könnte. Ein weiteres Problem ergibt sich durch Verunreinigungen. Aufgrund der extrem feinen Strukturen weisen bereits kleinste Verunreinigungen, beispielsweise nahezu nicht vermeidbare Staubteilchen, eine Dimension in der Größenordnung der aufzubringenden Strukturen auf. Gelangt eine Verunreinigung in den Prägebereich zwischen Stempel und Substrat, kommt es zu einer lokalen Verquetschung, was leicht zu einer Beschädigung des Substrats und/oder der am Stempel aufgebrachten Strukturen führen kann.

Nach der Aushärtung des Polymers muss der Stempel von diesem getrennt werden. Die große Oberfläche der Mikro- bzw. Nanostruktur erfordert zum Trennen beachtliche Kräfte, was dazu führen kann, dass sich das Polymer einerseits nur unvollständig vom Stempel löst, oder dass es sich andererseits auch vom Substrat löst. In beiden Fällen ist die geprägte Struktur unbrauchbar. Insbesondere erfordert ein unvollständiges Lösen des Polymers vom Stempel eine aufwändige Reinigungsprozedur des Stempels, die wiederum die Mikro- bzw. Nanostrukturen am Stempel beansprucht und somit die Einsatzdauer des Stempels reduziert. Da der Stempel oftmals nicht mechanisch fixiert in einer Stempelhalterung gehalten wird, sondern beispielsweise nur mittels einer Vakuumhalterung, kann es durch die hohen Abziehkräfte dazu kommen, dass der Stempel von der Halterung abgezogen wird und erneut in die Maschine geladen werden muss. Durch die erforderliche Reinigung bzw. durch den Austausch oder das erneute Laden des Stempels und der damit verbundenen Unterbrechung der Produktion, kommt es auch unmittelbar zu einer deutlichen Kostenerhöhung.

Einige der genannten Probleme lassen sich durch Verwendung eines so genannten weichen Stempels vermeiden bzw. verringern. Nachteilig ist jedoch, dass ein weicher Stempel eine geringere Formtreue besitzt und dass sich nicht so feine Strukturen prägen lassen.

Für eine möglichst rationelle und kostengünstige Herstellung großflächiger, mikro- bzw. nanostrukturierter Substrate ist es daher unbedingt erforderlich, dass der Prägevorgang zuverlässig durchgeführt wird. Entscheidend für die Zuverlässigkeit und Qualität der Prägung sowie eine lang andauernde Maßhaltigkeit des mikro- bzw. nanostrukturierten Stempels, ist eine möglichst schonende Verpressung des Stempels und des Imprint-Materials.

Der vorliegenden Erfindung liegt nun die Aufgabe zugrunde, einen Substrathalter zu schaf fen, der ein Nanoimprint Lithografieverfahren, beispielsweise ein UV-Nanoimprint Lithographieverfahren, dahingehend verbessert, dass ein möglichst schonender Prägevorgang erreicht wird, und gleichzeitig eine geringe und möglichst konstante Dicke der geprägten Schicht des Imprint-Materials sichergestellt werden kann.

Die Aufgabe der Erfindung wir dadurch gelöst, dass das funktionale Element des Substratträgers als Antriebsmittel ausgebildet ist. Weiters wird die Aufgabe der Erfindung durch die Merkmale des Kennzeichenteils von Anspruch 14 und Anspruch 22 gelöst.
Üblicherweise sind Substrathalter starre Vorrichtungen, die eine möglichst plane Oberfläche aufweisen, auf der das Substrat gehalten wird. Umfasst der Substratträger jedoch zumindest ein als Antriebsmittel ausgebildetes funktionales Element, ist es möglich, die Trägerlage des Substratträgers formändernd zu beeinflussen. Von besonderem Vorteil des erfindungsgemäßen Substratträgers ist, dass diese Beeinflussung dynamisch und während eines laufenden Prägevorgangs angepasst werden kann.

Ist das Antriebsmittel aus einem piezoelektrischen Material gebildet, sind für den Antrieb keine beweglichen Teile erforderlich. Dies ist insbesondere von Vorteil, da bewegliche bzw. sich bewegende Antriebsteile einem Verschleiß unterliegen und daher in Vorrichtungen von Nachteil sind, die auf eine möglichst lange Betriebsdauer ausgelegt sind. Weiters findet bei beweglichen Teilen immer auch ein geringer Materialabrieb statt, was dann besonders nachteilig ist, wenn das Antriebsmittel in einer Vorrichtung eingesetzt bzw. verwendet wird, wo es auch auf höchste Reinheit ankommt, beispielsweise in Reinräumen. Eine besonders vorteilhafte Weiterbildung des anspruchsgemäßen Substratträgers erhält man, wenn das piezoelektrische Material die Eigenschaft aufweist, sich transversal zum einwirkenden elektrischen Feld zu deformieren. Dies hat den bedeutenden Vorteil, dass durch die Form des Antriebsmittels und durch die Position der angebrachten Elektroden, die Richtung der Formänderung des Antriebsmittels gezielt vorgeben lässt.

In einer vorteilhaften Weiterbildung weist das piezoelektrische Material den piezoelektrischen Effekt d31 bzw. d32, auf. Ein bedeutender Vorteil des piezoelektrischen Effekts d31 ist, dass sich durch das angelegte elektrische Feld sowohl eine Kontraktion als auch eine Dehnung erzielen lässt.

Insbesondere ist jedes Material zur Bildung des Antriebsmittels geeignet, bei dem ein einwirkendes Feld, z.B. elektrisch, magnetisch, thermisch, etc., bzw. eine einwirkende elektromagnetische Strahlung, beispielsweise Licht, eine Deformation bewirkt.

Eine flächenhafte Trägerlage mit einer ersten und zweiten Auflagefläche lässt sich kostengünstig und rationell mit hinreichend hoher Genauigkeit herstellen.
Weist die zweite Flachseite der Trägerlage ein Haltemittel zum lösbaren Halten eines flächenhaften Objekts auf, insbesondere eines Substrats, ist sichergestellt, dass die Kontur der zweiten Flachseite der Trägerlage auf das Substrat übertragen wird. Das ist von entscheidendem Vorteil, da dadurch das Substrat jede Änderung der Kontur der ersten Flachseite der Trägerlage unmittelbar übernimmt. Insbesondere ist es anspruchsgemäß möglich die Trägerlage derart vorteilhaft zu verformen, um während des Prägevorgangs einen optimalen konformalen Kontakt zwischen Substrat bzw. Imprint-Material und Stempel zu erreichen.
Ist das Haltemittel durch eine Unterdruckhaltevorrichtung gebildet, ist in vorteilhafter Weise keine mechanische Halterung des Substrats von Nöten. Mechanische Halterungen bergen immer die Gefahr, dass es durch die erforderliche Klemmkräfte zu lokalen Überbeanspruchungen und dadurch zur Beschädigung des gehaltenen Objekts kommen kann. Durch den über die Auflagefläche des Substrats gleichmäßig vorhandenen Unterdruck wird das Substrat sicher und schonend gehalten. Weiters wird durch die anspruchsgemäße Ausbildung erreicht, dass eine Deformation der Trägerlage auf das gehaltene Substrat übertragen wird, ohne dass es zu lokalen Überbeanspruchungen des Substrats kommt.
Ist das Antriebsmittel mit der ersten Flachseite der Trägerlage verbunden, wirkt sich eine Formänderung des Antriebsmittels unmittelbar auf die Trägerlage des Substratträgers aus. Von entscheidendem Vorteil einer anspruchsgemäßen Ausbildung ist, dass das Antriebsmittel keine abstützende Vorrichtung benötigt, so dass sich die Formänderung direkt und unmittelbar auf die Trägerlage auswirkt.

Sind auf der ersten Flachseite der Trägerlage mehrere Antriebsmittel angeordnet, so lässt sich damit eine wesentlich feiner wirkende, formgebende Beeinflussung der Trägerlage erreichen. Da mit jedem Antriebsmittel nur eine bestimmte maximale Formänderung bzw. eine Maximalkraft erreichbar ist, ermöglicht es eine anspruchsgemäße Ausbildung, eine deutlich größere formgebende Beeinflussung zu erreichen, da sich die einzeln wirkenden Formänderungen überlagern. Zur Erzielung einer gewünschten Kraftverteilung bzw. Formänderung können daher in vorteilhafter Weise mehrere kleine Antriebsmittel eingesetzt werden.
Jedes mit der Flachseite der Trägerlage verbundene Antriebsmittel übt bei einer, durch ein angelegtes elektrisches Feld hervorgerufenen Formänderung, eine Kraft auf die Trägerlage aus, die dadurch ebenfalls deformiert wird. Die Formänderung kann aber bspw. auch durch ein einwirkendes magnetisches, thermisches, etc. Feld, bzw. durch eine einwirkende elektromagnetische Strahlung, beispielsweise Licht, hervorgerufen werden.

Sind nun mehrere Antriebsmittel strukturiert angeordnet, summieren sich die Einzeldeformationen zu einem gesamten Deformationsfeld. Durch diesen Summationseffekt ist es insbesondere möglich, die einzelnen Antriebsmittel gezielt anzusteuern, um so eine spezifische Kraftverteilung auf die Trägerlage einwirken zu lassen und damit einhergehend, eine spezifische Deformation der Trägerlage zu erreichen. Dies ist insbesondere von Vorteil wenn der Substratträger bevorzugt in eine bzw. mehrere Richtungen verformt werden soll. Dieser Summationseffekt kann weiters dazu genützt werden, um mit wenigen Antriebsmittel bereits eine große Krafteinwirkung und damit eine größere Deformation zu erzielen. Insbesondere ist das von Vorteil, wenn dadurch Antriebsmittel eingespart bzw. weniger leistungsstarke Antriebsmittel verwendet werden können. Von wesentlichem Vorteil einer anspruchsgemäßen Ausbildung ist, dass durch Anlegen eines elektrischen Felds an das Antriebsmittel, eine mechanische Deformation der Trägerlage erreicht wird.

Wenn zumindest ein Sensor vorhanden ist, lässt sich in vorteilhafter Weise eine Verformung der Trägerlage erkennen. Die Verformung kann beispielsweise von der Krafteinwirkung des Stempels während des Prägevorgangs herrühren, oder aber auch durch Unebenheiten des Substrat hervorgerufen werden, wenn dieses vom Substratträger gehalten wird. Ebenso führt eine Verunreinigung die zwischen Stempel und Substrat eingeklemmt ist, zu einer stärkeren lokalen Verformung, was insbesondere eine erhöhte Gefahr einer Beschädigung des Stempels birgt.

In einer vorteilhaften Weiterbildung kann der Sensor beispielsweise auch als optischer Sensor ausgebildet sein und Formänderungen dementsprechend auch optisch festgestellt werden. Ist der Sensor in vorteilhafter Weise aus einem funktionalen Werkstoff gebildet, bewirkt eine mechanische Deformation des Sensors eine Änderung des elektrischen Spannungsniveaus an den am Sensor angebrachten Elektroden. So bewirkt, z.B. bei piezoelektrischen Materialen, ein elektrisches Feld eine Formänderung und umgekehrt bewirkt eine Formänderung eine Spannungsänderung an den Elektroden. Von bedeutendem Vorteil ist dabei, dass ein und dasselbe piezoelektrische Material daher wahlweise sowohl als Antriebsmittel, als auch als Sensor verwendet werden kann.

Ist der Sensor mit der ersten Flachseite der Trägerlage verbunden, bewirkt eine Formänderung, insbesondere eine Krümmung bzw. eine Verzerrung der Trägerlage, die sich unmittelbar auf die Sensoren überträgt, eine Spannungsänderung an den am Sensor angebrachten Elektroden. Die anspruchsgemäße Ausbildung hat den weiteren Vorteil, dass durch eine entsprechende bauliche Formgebung des Sensors, die Wirkrichtung der Verformung festgestellt werden kann.

Sind auf der ersten Flachseite der ersten Trägerlage mehrere Sensoren angeordnet, lässt sich die Position und Stärke der Verformungen feiner aufgelöst bestimmen. Dies ist insbesondere von entscheidender Bedeutung wenn es darum geht, lokale begrenzte stärkere Verformungen sicher und zuverlässig zu erkennen. Derartige Verformungen entstehen aufgrund erhöhter lokaler Krafteinwirkung die beispielsweise auftreten, wenn eine Verunreinigung, beispielsweise ein Staubteilchen, beim Verpressen zwischen Stempel und Substrat gelangt, und somit das Eintauchen des Stempels in das Imprint-Material behindert. Da derartige Störeinflüsse lokal sehr begrenzt auftreten aber ein bedeutendes Schadpotential haben, ist es wesentlich, dass diese lokalen Kraftmaxima sicher erkannt werden.

Bei einer strukturierten Anordnung der Sensoren ist es möglich, verteilt über die Flachseite der Trägerlage auftretende Verformungen, zuverlässig zu erkennen und durch die Kombination bzw. Auswertung der Messgrößen der einzelnen Sensoren, auch die Position der Verformung zu bestimmen. Auch mit dieser Ausbildung wird der Summationseffekt von Kräften bzw. Deformationen ausgenützt. Durch eine überlegte Positionierung der Sensoren, reichen weniger Sensoren aus, um trotzdem eine Krafteinwirkung genau bestimmen zu können.
Eine besonders vorteilhafte Ausführung erhält man, wenn eine Vorrichtung zur Formung von Mikro- bzw. Nanostrukturen auf einem Substrat mit einem erfindungsgemäßen Substratträger ausgebildet ist, da sich dadurch Mikro- bzw. Nanostrukturen zuverlässig, mit hoher Qualität und unter größtmöglicher Schonung von Substrat und Stempel herstellen lassen.

Ist der Stempel aus einem für UV-Licht transparenten Material gebildet, beispielsweise aus Quarz oder PDMS (PolyDiMethylSiloxan), ist in vorteilhafter Weise eine Belichtung des Imprint-Materials durch den Stempel hindurch möglich. Dies ist insbesondere von Vorteil, wenn das Imprint-Material bevorzugt aus einem Polymer gebildet ist, das durch UV-Licht aushärtet und daher ein möglichst ungehindertes Einwirken des UV-Lichts auf das Imprint-Material von Nöten ist. Ein weiterer bedeutender Vorteil der anspruchsgemäßen Ausbildung ist, dass während des Prägevorgangs durch den Stempel hindurch eine optische Kontrolle der geprägten Strukturen möglich ist.

Wenn eine optische Aufnahmeeinrichtung vorhanden ist, erhält man mehrere vorteilhafte Weiterbildungen. Beispielsweise ist es möglich, einen Stempel mit Markierungen zu versehen die einen direkten Schluss auf die Belastung während des Prägevorganges zulassen. Diese Markierungen können von der optischen Aufnahmeeinrichtung aufgenommen und gegebenenfalls weiterverarbeitet werden. Eine weitere vorteilhafte Ausbildung könnte darin bestehen, dass die optische Aufnahmeeinrichtung durch den transparenten Stempel hindurch ein Bild der geprägten Struktur aufnimmt und dieses für eine weitere Bearbeitung zur Verfügung stellt. Dieses aufgenommene Bild könnte beispielsweise aber auch im Rahmen einer Qualitätssicherung zu Dokumentationszwecken genützt werden.

Ist die Vorrichtung anspruchsgemäß mit einer Regelungseinrichtung ausgestattet, ist vorteilhafter Weise eine unmittelbare Anpassung des Prägevorgangs möglich. Der bedeutende Vorteil ist dabei, dass Prozessgrößen, die während des Prägevorgangs ermittelt werden, von der Regelungseinrichtung ausgewertet und unmittelbar zur Steuerung des Prägevorgangs genutzt werden. Man erhält durch diese Rückkopplung eine positive Beeinflussung des Prägevorgangs, was mittelbar zu einer Qualitätssteigerung der geprägten Strukturen beiträgt. Insbesondere lässt sich durch eine gezielte Deformation des Substratträgers, ein vollständig flaches Aufliegen des Stempels am Substrat erreichen. Auch lassen sich Fremdkörper die sich zwischen Stempel und Substrat befinden, sicher erkennen und somit eine lokale Überbeanspruchung verhindern. Weiters ist eine Schwingungserzeugung bzw. Dämpfung in vorteilhafter Weise möglich.

Wenn die Regelungseinrichtung zur gezielten Beeinflussung der Antriebsmittel ausgebildet ist, lässt sich in vorteilhafter Weise eine gezielte Verformung der Trägerlage erreichen. Dies ist von bedeutendem Vorteil, um beispielsweise eine dem Prozess angepasste Krafteinwirkung auf das Substrat zu erreichen, wenn es durch Unebenheiten der Oberfläche des Substrats zu einem ungleichmäßigen Kontakt zwischen Stempel und dem Imprint-Material bzw. Substrat kommt. Insbesondere ist anspruchsgemäß eine möglichst optimale Schmiegefläche der Trägerlage an das Substrat erreichbar.

Ist die Regelungseinrichtung dazu ausgebildet, die von der optischen Aufnahmeeinrichtung bereitgestellten Bilder auszuwerten, kann ein Regelsignal erzeugt werden, mit dem sich der Prägevorgang qualitätssteigernd beeinflussen lässt. Beispielsweise können von der optischen Aufnahmeeinrichtung Verformungen des Stempels bzw. bei einem transparenten Stempel auch das Prägebild dazu herangezogen werden, ein Regelsignal für die Anpassung für die Anpassung der Trägerlage zu erzeugen. Weiters kann durch den Verlauf des, durch den Prägevorgang, weggedrückten Imprint-Materials, eine qualitative Beurteilung des erzielten Prägebilds vorgenommen werden.

Weitere vorteilhafte Maßnahmen liegen darin, die Regelungseinrichtung zur Auswertung der von den Sensoren ermittelten Prozessgrößen auszubilden. Die ermittelten Prozessgrößen, wie beispielsweise eine einwirkende Kraft, Unebenheit des Substrats, können in vorteilhafter Weise dazu verwendet werden, die Qualität des Prägevorgangs positiv zu beeinflussen. Insbesondere ist mit dieser Ausbildung eine Erhöhung der Zuverlässigkeit des Prägevorgangs sowie eine Schonung des Prägestempels erreichbar, wodurch sich insbesondere eine deutliche Steigerung der Wirtschaftlichkeit erzielen lässt, da dadurch mit einem Stempel bedeutend mehr Prägevorgänge durchgeführt werden können.

Ist die Verfahrvorrichtung zur Bewegung des Stempels in Richtung parallel zur Ebene der Trägerlage ausgebildet, lassen sich auf einem Substrat hintereinander mehrere Prägevorgänge ausführen. Da weder Substrat noch Stempel absolut plane Flachseiten aufweisen und dadurch mit zunehmender Stempelfläche hochqualitative Prägevorgänge noch bedeutend schwieriger werden als bei kleinen Stempelflächen, werden kleinere Stempel eingesetzt, die jedoch mehrere, höchst präzise positionierte, Prägevorgänge erforderlich machen. Von Vorteil der anspruchsgemäßen Ausbildung ist, dass der Prägevorgang an jeder beliebigen Stelle des Substrates und mit hoher Genauigkeit durchgeführt werden kann.

Weiters erlaubt ein anspruchsgemäß ausgebildeter Substrathalter die Verwendung von deutlich größeren Stempeln, was die Anzahl der notwendigen Prägevorgänge reduziert und so den Durchsatz erhöht.

Wird in einem Imprint Lithografieverfahren zur Formung von Mikro- bzw. Nanostrukturen auf einem Substrat eine erfindungsgemäße Vorrichtung verwendet, erhält man den bedeutenden Vorteil, dass sich Mikro- bzw. Nanostrukturen zuverlässiger, kostengünstiger und mit höherer Qualität herstellen lassen, als es mit den bisher bekannten Imprint Lithographieverfahren möglich war. Von weiterem Vorteil ist, dass das Verfahren einen schonenden Prägevorgang sicherstellt, was sich unmittelbar auf die Lebensdauer des Stempels auswirkt. Weiters ist das anspruchsgemäße Imprint Lithographieverfahren wesentlich flexibler an verschiedenste Substrate und an die zu prägenden Strukturen anpassbar, da jeder beliebiger Abschnitt am Substrat gezielt angesteuert werden kann.

Wird bei einer Krafteinwirkung normal zur Flachseite der Trägerlage, vom Sensor eine Spannung abgegeben, lässt sich daraus ein Signal ableiten, das direkt proportional zur Kraftverteilung auf dem Substrat und damit unmittelbar auf die Trägerlage ist. Eine Auswertung dieses Signals erlaubt Rückschlüsse auf die Belastung des Substrats bzw. des Stempels während des Prägevorgangs zu ziehen.

Das durch die Krafteinwirkung hervorgerufene lokale Deformationsfeld, bspw. durch eine eingeschlossene Verunreinigung oder eine unebene Kontaktfläche zwischen Stempel und Substrat, bewirkt bei den im betroffenen Bereich liegenden Sensoren ebenfalls eine Deformation und dadurch eine elektrische Spannung an den Elektroden. Dieses elektrische Signal lässt sich dazu verwenden die Antriebsmittel derart gezielt anzusteuern, um der Deformation nachzugeben und damit eine Schmiegefläche an die Umgebung zu bilden. Dadurch wird der Auflagedruck gezielt in jenen Abschnitten verringert, in denen es durch die Verunreinigung bzw. Unebenheit zu einem erhöhten Kraftanstieg kam und somit eine mögliche Beschädigung des Stempels verhindert.

Ist das Antriebsmittel dazu ausgebildet, die Trägerlage in der Ebene parallel zu ihrer Auflagefläche zu deformieren, erhält man den bedeutenden Vorteil, dass ein vom Substratträger gehaltenes Substrat relativ zum Stempel deformiert werden kann. Dadurch ist es beispielsweise möglich, das Substrat gegen den Stempel auszurichten, um so ein punktgenaues Prägen der Struktur sicherzustellen. Dies ist insbesondere von Vorteil, da aufgrund der extrem feinen zu prägenden Strukturen, bereits geringste Ungenauigkeiten bei der Positionierung zu einer unbrauchbaren Struktur führen können. Der Stempel wird von der Verfahrvorrichtung so genau als möglich über dem zu prägenden Abschnitt des Substrats positioniert, die exakte Ausrichtung und Anpassung erfolgt durch eine lokale Deformation des Substratträger.

Da das Substrat vom Substratträger gehalten ist, überträgt sich eine Formänderung der Trägerlage des Substratträgers auch auf das Substrat. Ist nun das Antriebsmittel dazu ausgebildet, die Trägerlage in Richtung normal zu ihrer Auflagefläche zu verformen, ist eine gezielte Beeinflussung der Auflagefläche der Trägerlage und damit auch der Oberfläche des Substrats möglich. In besonders vorteilhafter Weise ist es mit dem anspruchsgemäß ausgebildeten Antriebsmittel möglich, Unregelmäßigkeiten der Oberfläche auszugleichen.

Von bedeutendem Vorteil ist eine anspruchsgemäße Ausbildung, bei der die Antriebsmittel von der Regelungseinrichtung selektiv gesteuert werden. Da die Regelungseinrichtung zur Auswertung von Prozessgrößen, beispielsweise Deformation bzw. Unebenheit der Trägerlage bzw. des Substrats und/oder zur Auswertung von optischen Prozessgrößen, die von der optischen Aufnahmevorrichtung geliefert werden, ausgebildet ist, ist eine besonders vorteilhafte Anpassung des Prägevorgangs bereits während der stattfindenden Prägung möglich. Es ist also nicht erforderlich, zuerst den Prägevorgang abzuschließen, um hernach durch Analyse des Prägebilds die Parameter für einen weiteren Prägevorgang anzupassen, sondern durch die Regelschleife wird ein jeder Prägevorgang optimiert und so eine hohe Qualität jeder Prägung erreicht.

Beim Prägen wird der Stempel in das noch nicht ausgehärtete Imprint-Material gedrückt. Durch die am Stempel aufgebrachte Mikro- bzw. Nanostrukturierung gibt es Abschnitte, in denen das Imprint-Material weggedrückt wird, in anderen Abschnitten bleibt das Imprint-Material in seiner ursprünglichen Dicke bestehen. Bevorzugt ist die Mikro- bzw. Nanostruktur am Stempel derart ausgebildet, dass es Abschnitte gibt, in die das verdrängte Imprint-Material gedrückt wird. Durch Ungenauigkeiten der Schichtdicke des Imprint-Material kann es jedoch vorkommen, dass nicht alles Material weggedrückt wird und es so zu lokalen Druckspitzen kommt die zu einer erhöhten Kraftwirkung auf das Substrat führen. Wird der Substratträger derart verformt, dass sich eine Kontaktfront bildet, die sich mit einer vorgebbaren Geschwindigkeit und einer vorgebbaren Richtung durch den Substratträger bewegt, findet der erste Kontakt zwischen Stempel und Imprint-Material auch nur entlang dieser Kontaktfront statt. Insbesondere ist es anspruchsgemäß möglich, den ersten Kontaktpunkt zwischen Stempel und Imprint-Material genau vorgeben zu können. Beim so genannten Droplet-Imprinting ist es erforderlich, dass der Erstkontakt am Ort des Tropfens am Substrat stattfindet und sich die Kontaktfront dann nach außen bewegt. Ist das Imprint-Material durch Schleudern aufgebracht (spin coating), findet der Erstkontakt bevorzugt an einem durch die genaue Anordnung der Strukturen am Stempel definierten Punkt statt. Der vorgebbare Erstkontakt sowie die bestimmbare Richtung der durchlaufenden Kontaktlinie ist von besonderem Vorteil, da dadurch eventuell vorhandenes überschüssiges Material vor dem Stempel hergedrückt wird und es weiters verhindert wird, dass Luftblasen zwischen Substrat und Stempel eingeschlossen werden. Ein weiterer Vorteil der anspruchsgemäßen Ausbildung zeigt sich beim Trennen des Stempels vom Imprint-Material. Durch die große Oberfläche des mikro- bzw. nanostrukturierten Materials sind die Kräfte zum Trennen von Stempel- und Imprint-Material sehr hoch, was zu Problemen im Hinblick auf eine saubere Entformung führen kann. Wird auch zum Trennen von Stempel und Substrat die Trägerlage des Substratträgers derart verformt, dass sich eine Trennfront bildet, die sich durch den Substratträger bewegt, findet die Trennung von Stempel und Imprint-Material nur entlang der Linie der durchlaufenden Trennfront statt, was eine deutliche Reduktion der haftenden Oberfläche und damit der zur Trennung erforderlichen Kraft bedeutet. Der bedeutende Vorteil ist dabei, dass dadurch die Gefahr von Beschädigungen des Stempels bzw. des Prägebilds deutlich geringer ist. Die oben genannten Vorteile einer durchlaufenden Kontaktfront lassen sich auch auf die Trennfront anwenden.

Eine weitere vorteilhafte Ausbildung erhält man, wenn der Substratträger zu Mikroschwingungen angeregt wird, da sich diese auch auf das Substrat übertragen und so die Verteilung des weggedrückten Materials begünstigen und weiters mithelfen, den Stempel vom Imprint-Material zu trennen. Durch die äußerst geringen Verformungen, die durch die Mikroschwingungen hervorgerufen werden, sind auch sehr feine Strukturen schonend und sicher entformbar. Weiters können einige Antriebsmittel gezielt zur Erregung von Resonanzschwingungen eingesetzt werden, um so ebenfalls die Trennung von Stempel und Imprint-Material zu erleichtern.

Die Erfindung wird im nachfolgenden anhand der in den Zeichnungen vereinfacht und schematisch dargestellten Ausführungsbeispiele näher erläutert.

Es zeigen:
- Fig. 1: einen Schnitt in horizontaler Richtung durch erfindungsgemäßen Substratträger;
- Fig. 2: a) und b) eine Ansicht von der ersten Flachseite des erfindungsgemäßen Substratträgers zur Darstellung zweier möglicher Anordnungen der funktionalen Elemente;
- Fig. 3: eine schematische Darstellung einer Vorrichtung zur Formung von Mikro- bzw. Nanostrukturen auf einem Substrat, wobei ein erfindungsgemäßer Substratträger verwendet wird;
- Fig. 4: eine stark übertriebene Darstellung eines verformten erfindungsgemäßen Substratträger, wo der Stempel das mikro- bzw. nanostrukturierte Abbild in das Imprint-Material prägt;
- Fig. 5: weitere mögliche Ausbildungen des erfindungsgemäßen Substratträgers;
- Fig. 6: schematisch wie eine Schmiegefläche an die Umgebung gebildet wird.

Einführend sei festgehalten, dass in den unterschiedlich beschriebenen Ausführungsformen gleiche Teile mit gleichen Bezugszeichen bzw. gleichen Bauteilbezeichnungen versehen werden, wobei die in der gesamten Beschreibung enthaltenen Offenbarungen sinngemäß auf gleiche Teile mit gleichen Bezugszeichen bzw. gleichen Bauteilbezeichnungen übertragen werden können. Auch sind die in der Beschreibung gewählten Lageangaben, wie z.B. oben, unten, seitlich usw. auf die unmittelbar beschriebene sowie dargestellte Figur bezogen und sind bei einer Lageänderung sinngemäß auf die neue Lage zu übertragen. Weiters können auch Einzelmerkmale oder Merkmalskombinationen aus den gezeigten und beschriebenen unterschiedlichen Ausführungsbeispielen für sich eigenständige, erfinderische oder erfindungsgemäße Lösungen darstellen.

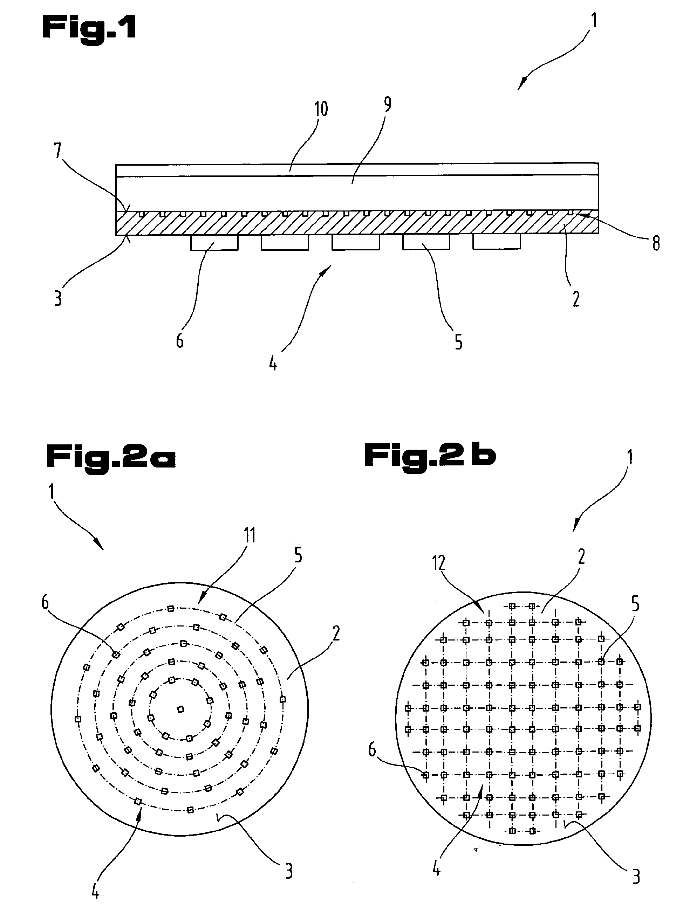

Fig. 1 zeigt eine vereinfachte Darstellung des erfindungsgemäßen Substratträgers 1. Dieser umfasst eine flächenhafte Trägerlage 2, wo auf deren ersten Flachseite 3 funktionale Elemente 4 angebracht sind, insbesondere Antriebsmittel 5 und Sensoren 6 und auf deren zweiten Flachseite 7 ein Haltemittel 8 angebracht ist. Das Haltemittel ist dazu ausgebildet, ein flächenhaftes Substrat 9 zuverlässig auf der zweiten Flachseite 7 zu halten. Auf dem Substrat 9 ist beispielsweise vollflächig das Imprint-Material 10 aufgebracht, in die mikro- bzw. nanostrukturierte Abschnitte geprägt werden. In einer Weiterbildung kann das Imprint-Material auch tropfenförmig aufgebracht sein, aber auch andere Arten der Aufbringung sind denkbar. Bevorzugt ist das Haltemittel 8 als Unterdruckhaltemittel ausgebildet. In einer Weiterbildung kann das Haltemittel beispielsweise aber auch mechanisch verriegelnd bzw. klemmend, magnetisch oder elektrostatisch haltend ausgebildet sein. Wesentliches Merkmal des Haltemittels ist, dass eine Formänderung der Trägerlage 2 auch auf das gehaltene Substrat 9 übertragen wird.

Flächenhafte Substrate weisen immer eine gewisse Welligkeit der Oberfläche auf, sie sind also nie völlig plan. Selbst bei einem der besten verfügbaren Substrate, einem Siliziumwafer, liegt die typische Welligkeit der Oberfläche im Bereich von einigen 10 µm. Auch die eingesetzten Prägestempel besitzen eine langreichweitige Welligkeit in diesem Bereich. Weiters ist die Dicke des Imprint-Materials üblicherweise in der Größenordnung der Tiefe der Mikro- bzw. Nanostrukturen am Stempel. Beim Prägen des mikro- bzw. nanostrukturierten Abbilds in das Imprint-Material, ergibt sich daher das Problem, dass Stempel und Imprint-Material meist nicht ganzflächig in Kontakt sind, da die zu prägenden Strukturen üblicherweise wesentlich kleiner als die Oberflächenwelligkeit sind, zumeist um mindestens zwei Größenordnungen.

Die funktionalen Elemente 4 sind an der ersten Flachseite 3 der Trägerlage 2 angebracht. Durch diese vorteilhafte Anbringung ist es nicht erforderlich, dass eine zusätzliche Haltevorrichtung zur Abstützung der funktionalen Elemente vorhanden ist. Da die funktionalen Elemente durch ein piezoelektrisches Material gebildet sind erreicht man, dass die Elemente beim Anlegen einer Spannung in einer bestimmten Vorzugsrichtung, ihre Form ändern.

Durch entsprechende bauliche Ausgestaltung der funktionalen Elemente, insbesondere durch die Formgebung des Materials und die Position der Kontaktelektroden, erhält man eine bevorzugte Richtung der Formänderung. Zur Erzielung der erfindungsgemäßen Effekte werden die Antriebsmittel 5 bevorzugt dahingehend ausgebildet, dass die Formänderung in Richtung parallel zur ersten Flachseite 3 der Trägerlage auftritt, wobei auch andere Wirkrichtungen denkbar sind. Da die Antriebsmittel 5 mit der ersten Flachseite 3 der Trägerlage verbunden sind, ist eine ungehinderte Formänderung beim Anlegen einer elektrischen Spannung nicht möglich. Infolge dessen übt das Antriebsmittel eine Kraft, insbesondere ein Biegemoment auf die erste Flachseite der Trägerlage aus, das umso stärker sein wird, je höher die angelegte elektrische Spannung ist.

In ähnlicher Weise ruft eine Deformation der Trägerlage eine Dehnung bzw. Kontraktion oder eine Biegung an einem an der ersten Flachseite 3 der Trägerlage angebrachten Sensor 6 hervor. Wenn auch der Sensor aus einem piezoelektrischen Material gebildet ist, führt diese Dehnung bzw. Kontraktion oder die Biegung zu einer elektrischen Spannungsänderung an den Elektroden. Die Krafteinwirkung kann beispielsweise daher rühren, dass ein Stempel in das Imprint-Material 10 am Substrat 9 drückt, oder aber von Unregelmäßigkeiten der Substratoberfläche, die sich durch die Halterung auf die Trägerlage übertragen.

Fig. 2a und Fig. 2b zeigen zwei unterschiedliche Strukturen, wie funktionale Elemente 4 an der ersten Flachseite 3 der Trägerlage angeordnet werden können. In Fig. 2a sind die funktionalen Elemente beispielsweise auf Kreisbahnen 11 angeordnet, wobei jedes funktionale Element im Wesentlichen auf einen flächenmäßig gleichen Abschnitt der Tragerlage wirkt. Fig. 2b zeigt eine gitterartige Anordnung 12 der funktionalen Elemente. Durch geeignete Wahl der Positionen an denen ein Antriebsmittel 5 bzw. ein Sensor 6 angebracht ist und durch die Summation der einzeln wirkenden Beeinflussungen, lässt sich das Auflösungsvermögen sowohl für eine Verformung der Trägerlage 2, als auch für die Erkennung einer Krafteinwirkung, genau definiert festlegen. Die Antriebsmittel bzw. Sensoren können auch mittels eines Aufdampfungsprozesses gleichmäßig verteilt sein, wodurch man eine gleichmäßig verteiltes elektrisches Reaktions- bzw. mechanisches Aktionspotential erhält. Ebenso können funktionalen Elemente aufgedampft und danach strukturiert werden. Von Vorteil ist jeweils, dass die Form, die Position und die Anzahl der funktionalen Elemente sehr einfach, insbesondere mittels Strukturierungsverfahren, herstellbar ist. Sind beispielsweise die funktionalen Elemente 4 überwiegend aus einem piezoelektrischen Material gebildet, kann aufgrund des reziproken piezoelektrischen Effekts, jedes funktionale Element 4 sowohl als Antriebsmittel 5 als auch als Sensor 6 eingesetzt werden. Dadurch ist es beispielsweise möglich, die Anordnung von Antriebsmittel und Sensoren zu ändern, ohne die physikalische Position der funktionalen Elemente ändern zu müssen. Die Auswahl der Funktion, der Betriebsart, wird von einer Steuer- bzw. Regelungseinrichtung übernommen. Wird das funktionale Element mit einer elektrischen Spannung beaufschlagt, funktioniert es als Antriebsmittel. Wird die Spannung an den angebrachten Elektroden gemessen, funktioniert es als Sensor.

Insbesondere ist es jedoch möglich, die Auswahl der Betriebsart kontinuierlich und auch während eines laufenden Verarbeitungsschritts vorzunehmen. Jedes einzelne Antriebsmittel 5 erreicht, abhängig von seiner Größe, bei schrittweiser Erhöhung der angelegten elektrischen Spannung ein lokales Deformationsfeld. Bei Kontakt des Substrats 9 am Substratträger 2 mit einem umgebenden Gegenstand, beispielsweise dem Stempel 13 oder einer zwischen Stempel 13 und Imprint-Material 10 eingeschlossenen Verunreinigung, kommt es zu einer erhöhten Krümmung bzw. Dehnung im Bereich der benachbarten, als Sensoren 6 betriebenen funktionalen Elemente 4. Diese Krümmung bewirkt wiederum, dass an den Elektroden der Sensoren eine Spannung anliegt, die von der Regeleinrichtung gemessenen und abgespeichert bzw. hinterlegt wird. Dieser Vorgang wird für jedes einzelne funktionale Element wiederholt, wodurch hernach für jedes einzelne Element eine Spannung zur Erreichung des Kontakts mit einem umgebenden Gegenstand abgelegt ist. Dann werden alle, nun als Antriebsmittel 5 betriebenen funktionalen Elemente 4 mit der jeweils hinterlegten Spannung beaufschlagt, wodurch sich die Trägerlage 2 derart verformt, dass sie eine Schmiegefläche an die Umgebung bildet. Ein bedeutender Vorteil dieser Ausbildung ist, dass der Druck der durch die zweite Flachseite 7 der Trägerlage 2 auf das gehaltene Substrat 9 ausgeübt wird, gezielt in jenen Abschnitten verringert wird, in denen der Imprintvorgang durch eine Verunreinigung zwischen Stempel 13 und Substrat 9 gestört ist. Dadurch kommt es zu keiner Überlastung und damit möglichen Beschädigung des Stempels.

Die Anordnung der funktionalen Elemente 4 des erfindungsgemäßen Substratträgers 1, ist jedoch nicht auf die dargestellten Varianten beschränkt. Beispielsweise ist es möglich, ein funktionales Element 4 derart auszubilden, dass nicht nur eine Vorzugsrichtung des piezoelektrischen Effekts existiert, sondern dass beispielsweise die Richtung der Kraftwirkung in einem weiten Bereich vorgebbar ist. Es ist weiters denkbar, großflächige funktionale Elemente einzusetzen, die durch eine äußere Beschaltung eine gewünschte Deformation hervorrufen können.

Weiters ist es in einer Variante denkbar, anstelle von piezoelektrischen Antriebsmittel beispielsweise andere aktuatorische Prinzipien einzusetzen. Beispielsweise könnten hydraulische bzw. pneumatische Stempel bzw. elektrische Linearantriebe wirkverbunden mit der ersten Flachseite der Trägerlage eingesetzt werden, um so die gewünschten Verformungen zu erhalten.

Weiters ist es denkbar, dass zur Bildung der Antriebsmittel bzw. Sensoren auch andere funktionale Werkstoffe verwendet werden, beispielsweise pyroelektrische, ferroelekrische, magnetische und magnetorheologische Werkstoffe. Ebenso sind auch verschiedenste Ausbildungsformen denkbar, beispielsweise faserartig oder in einem Elastomer eingebettet.

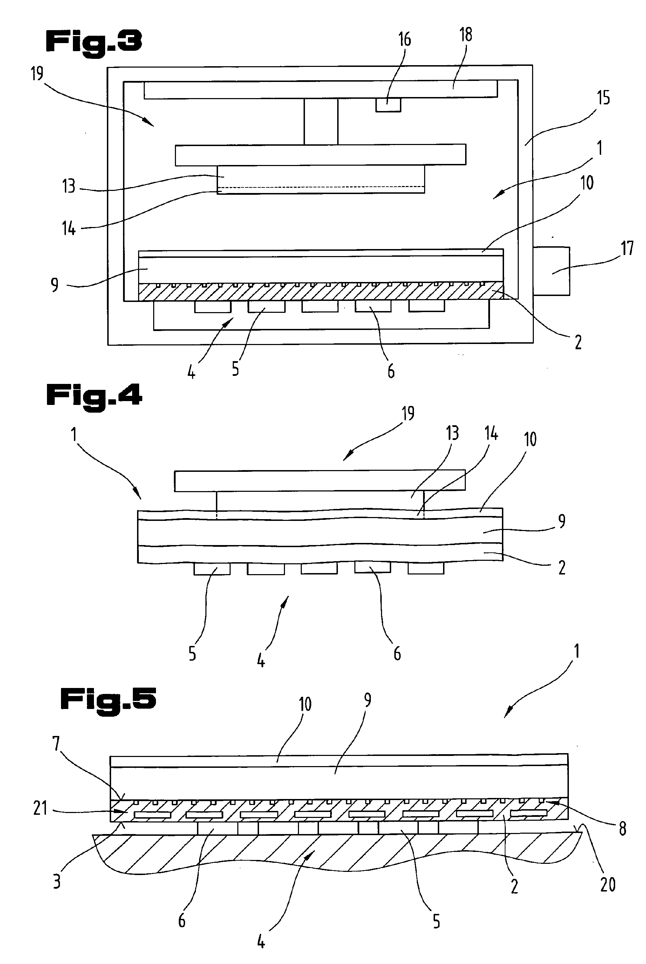

Fig. 3 zeigt eine stark vereinfachte Vorrichtung zur Herstellung von Mikro- bzw. Nanostrukturen auf einem Substrat. Die Vorrichtung umfasst den erfindungsgemäßen Substratträger 1 sowie einen Stempel 13 auf dem ein mikro- bzw. nanostrukturiertes Abbild 14 angebracht ist. Der Substratträger 1 und der Stempel 13 sind in einer Verfahrvorrichtung 15 gehalten angeordnet, wobei der Stempel in einer Positioniervorrichtung 18 gehalten ist, die eine freie Positionierung über der Fläche des Substrats ermöglicht. Zur Auswertung der Prozessgrößen, die von den Sensoren 6 und/oder von einer optischen Aufnahmeeinheit 16 geliefert werden, ist eine Regelungseinrichtung 17 vorhanden, die ihrerseits die Antriebsmittel 5 ansteuert, um so einen möglichst gleichmäßigen Auflagedruck des Stempels 13 am Substrat 9 bzw. am Imprint-Material 10 zu erreichen.

Da die Herstellung mikro- bzw. nanostrukturierter Stempel 13 sehr aufwändig und sehr teuer ist, werden üblicherweise Stempel eingesetzt, die kleiner sind als die Fläche des Substrats und daher mehrere Stempelvorgänge erforderlich machen. Um den Stempel nach einem ersten Prägevorgang über einem neuen Abschnitt des Substrats zu positionieren, ist der Stempel in einer Positioniervorrichtung 18 gehaltert. Die Positioniervorrichtung muss einerseits einen großen Aktionsbereich aufweisen, typische Substratdurchmesser liegen im Bereich 100 bis 300 mm, und andererseits eine sehr hohe Positioniergenauigkeit im Bereich einiger Nanometer aufweisen, was schwierig realisierbar ist. In einer vorteilhaften Weiterbildung des erfindungsgemäßen Substratträgers 1 ist dieser dazu ausgebildet, die Trägerlage 2 in der zur Flachseite 3 parallelen Richtung zu bewegen. Dadurch ist es möglich, den Stempel 13 durch die Positioniervorrichtung 18 über dem nächsten Prägeabschnitt zu positionieren und die Feinposition im Nanometerbereich durch den Substratträger durchführen zu lassen. Dadurch erhält man eine bedeutende Steigerung der Positioniergenauigkeit, was sich unmittelbar in einer größeren Genauigkeit der geprägten Strukturen auswirkt. Der angegeben Bereich für des Substratdurchmessers ist jedoch nicht einschränkend zu sehen. Es lassen sich auch Substrate mit größerem Durchmesser im erfindungsgemäßen Substratträger verwenden.

Sind mit der ersten Flachseite 3 der Trägerlage 2 mehrere Sensoren 6 verbunden und liefern den Prozessgrößen proportionale Ausgangssignale, können diese von der Regelungseinrichtung 17 ausgewertet werden, um daraus entsprechende Ansteuersignale für die Antriebsmittel 5 zu erzeugen. Obwohl der Prägevorgang üblicherweise in Reinräumen durchgeführt wird, kann es vorkommen, dass sich zwischen Stempel 13 und Substrat 9 ein Staubkorn befindet. Beim Pressen des Stempels in das Imprint-Material 10, kommt es an der Stelle dieser Verunreinigung zu einer deutlich erhöhten Krafteinwirkung auf das Substrat 9 und somit Krümmung bzw. Dehnung der Trägerlage. Sind auf der ersten Flachseite 3 der Trägerlage 2 mehrere Sensoren 6 strukturiert angeordnet, werden die Sensoren in den betroffenen Bereich eine Änderung der Spannung an die Regelungseinrichtung 17 liefern. Diese kann aus den Spannungsverläufen feststellen, dass es zu einer lokalen Überlastung kommt und die Antriebsmittel derart ansteuern, dass sie eine Verformung der Trägerlage und auch des gehaltenen Substrats bewirkt. Dadurch wird also der Spalt zwischen Stempel und Substrat vergrößert, wodurch es zu keiner Beschädigung des Stempels durch das Staubkorn kommt.

Ist eine optische Aufnahmeeinrichtung 16 vorhanden, kann diese weitere Prozessgrößen ermitteln, die von der Regelungseinrichtung 17 zur qualitätssteigernden Beeinflussung des Prägevorgangs ausgewertet werden können. In einer vorteilhaften Weiterbildung der erfindungsgemäßen Vorrichtung ist der Stempel 13 aus einem für UV-Licht transparenten Material hergestellt. Mit der optischen Aufnahmeeinrichtung 16 ist es dann möglich, direkt das Druckbild aufzunehmen und zwar insbesondere den Verlauf des weggedrückten Materials, um so eine qualitative Beurteilung des Prägebilds vornehmen zu können.

Da die erfindungsgemäße Vorrichtung nicht nur auf Stempel aus einem harten Material, insbesondere Quarz, eingeschränkt ist, lassen sich auch Stempel aus einem weichen Material, beispielsweise PDMS, einsetzen.

Weiters können an der mikro- bzw. nanostrukturierten Oberfläche 14 des Stempels gegenüberliegenden Seite Markierungen angebracht sein. Mit Hilfe der optischen Aufnahmeeinrichtung 16 ist es somit möglich, Verformungen, die durch eine ungleichmäßige Krafteinwirkung während des Prägevorgangs auftreten und somit zu einer Verschiebung der Markierungen führen, zu erkennen. Diese Information kann die Regelungseinrichtung auswerten um die Antriebsmittel derart zu steuern, dass ein gleichmäßiger Prägedruck erreicht wird. Fig. 4 zeigt den erfindungsgemäßen Substratträger 1 und den Stempel 13 während eines Prägevorgangs, wobei die Trägerlage 2 durch die Antriebsmittel 5 wellenförmig verformt ist. Das mikro- bzw. nanostrukturierte Abbild 14 wird vom Stempel 13 in das Imprint-Material 10 gedrückt, wobei es durch Unregelmäßigkeiten der Oberfläche sowohl des Substrats 9, als auch des Stempels 13, zu einer ungleichmäßigen Kraftverteilung auf die Oberfläche des Substrats kommt, die sich auf die Trägerlage 2 fortsetzt. Die ungleichmäßige Kraftverteilung wird von den Sensoren 6 aufgenommen und an die Regelungseinrichtung übermittelt. Diese leitet daraus Steuersignale für die Antriebsmittel 5 ab, um die Trägerlage und damit das Substrat derart zu verformen, dass ein ausgeglichener Kraftverlauf über die zu prägende Fläche erreicht wird.

Fig. 5 zeigt weitere Ausbildungen des erfindungsgemäßen Substratträgers. Um auf die Trägerlage 1 auch Zug- bzw. Druckkräfte ausüben zu können ist es möglich, die funktionalen Elemente 4 des Substratträgers 1 mit einer Auflagefläche 20 einer Unterlage zu verbinden, um so eine mechanische Abstützung gegen die Umgebung, beispielsweise gegen Verfahrvorrichtung, zu erreichen.

In einer weiteren Ausbildung sind die funktionalen Elemente 21 beispielsweise in die Trägerlage 2 integriert angeordnet. Durch diese Ausbildung können neben reinen Biegedeformationen auch ebene Verzerrungen, in Richtung parallel zur Ebene der Flachseiten, hervorgerufen werden. Diese ebenen Verzerrungen überlagern sich mit den Biegeverzerrungen und erlauben somit eine Vielzahl unterschiedlicher Deformationen hervorzurufen bzw. zu unterdrücken.

Von Vorteil ist weiters, dass durch die lokal erzeugbaren Deformationen, insbesondere durch Dehnungen in der Ebene, ein Abschnitt des Substrats parallel zur Flachseite der Trägerlage bewegt werden kann. Dadurch ist es beispielsweise möglich, das Substrat genau auf den Stempel auszurichten und somit eine wesentliche Erhöhung der Prägegenauigkeit zu erreichen.

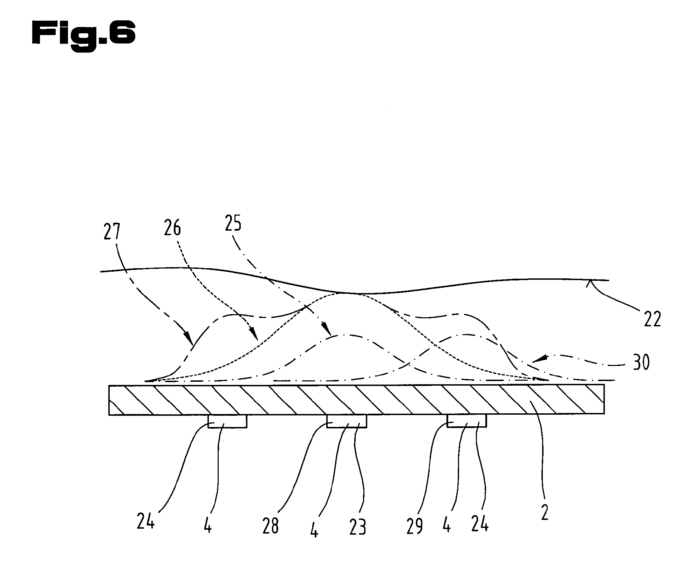

Fig. 6 zeigt schematisch, wie mit dem erfindungsgemäßen Substratträger 2 eine Schmiegefläche an eine unebene Kontaktfläche 22 erreicht wird bzw. wie sich ein Fremdkörper 22 zuverlässig erkennen lässt. Zur Vereinfachung ist in der Figur nur ein kleiner Ausschnitt des Substratträgers dargestellt, weiters ist kein Substrat dargestellt. Die Erklärungen gelten jedoch analog auch für ein am Substratträger aufgebrachtes Substrat.

Wie bereits zuvor bei Fig. 2 beschrieben, lässt sich ein funktionales Element 4 sowohl als Sensor, als auch als Antriebsmittel einsetzen. Für den ersten Deformationsvorgang zur Erzeugung einer Schmiegefläche wird ein funktionales Element als Antriebsmittel 23 betrieben, die beiden anderen funktionalen Elemente dienen als Sensoren 24. Wird an das Antriebsmittel eine elektrische Spannung angelegt kommt es zu einer Verformung desselben, was sich auch auf den Substratträger auswirkt und diesen ebenfalls verformt 25. Wird die angelegte elektrisch Spannung weiter erhöht, kommt es zu einer entsprechend stärkeren Verformung des Substratträgers 26 und schließlich zum Kontakt mit einer Oberfläche 22. Bis zu diesem Zeitpunkt stellt sich im Bereich der Sensoren 24 ein annähernd gleichmäßiger Anstieg der Deformation ein, was auch zu einem annähernd gleichmäßigen Anstieg der an den Elektroden anliegenden elektrischen Spannung führt. Wird nun die elektrische Spannung am Antriebsmittel 23 weiter erhöht, kann sich der Substratträger aufgrund des Kontakts mit der Oberfläche 22 nicht weiter verformen und es kommt zu weiteren seitlichen Deformationsmaxima 27, was einem plötzlichen, stärkeren Anstieg der Deformation im betroffenen Bereich entspricht. In der von den Sensoren 24 abgegebenen Spannung ist dieser Knick im Anstieg der Spannung deutlich zu bemerken.

Für den zweiten Deformationsvorgang wird das zuvor als Antriebsmittel 23 verwendete funktionale Element 4 als Sensor 28 verwendet und ein Sensor 24 von zuvor dient nun als Antriebsmittel 29. Bei Anlegen einer elektrischen Spannung bildet sich wiederum eine Deformation aus 30, die weiteren Verhältnisse sind analog den zuvor beschriebenen.

Dieser Vorgang wird für den Großteil der funktionalen Elemente wiederholt, wobei für jedes Antriebsmittel die elektrische Spannung zur Erreichung des Kontakts zwischengespeichert wird. Werden hernach alle funktionalen Elemente mit der jeweils hinterlegten Spannung beaufschlagt, stellt sich die jeweils zur Kontaktbildung erforderliche Deformation ein und der Substratträger bildet die Schmiegefläche an die Oberfläche. Dieser Anpassungsvorgang findet kontinuierlich statt und stellt somit eine zuverlässige und den Stempel schonende Prägung sicher.

Ähnliche Verhältnisse gelten für den Fall, dass ein Fremdkörper im Imprintabschnitt eingeschlossen ist. Hier würde von den Sensoren im betroffenen Abschnitt deutlich vor den anderen umliegenden Sensoren ein Kontakt mit einer Oberfläche festgestellt werden. Das funktionale Element bzw. die Elemente im betroffenen Bereich können dem entgegenwirken und durch eine andersgerichtete Deformation Platz für den Fremdkörper schaffen.
Der erfindungsgemäße Substratträger kann weiters vorteilhaft zur Unterdrückung von Schwingungen bzw. zur Dämpfung von Vibrationen verwendet werden. Auch hier ermöglicht wiederum der wahlweise Betrieb der funktionalen Elemente als Antriebsmittel bzw. als Sensor in Kombination mit der Regelungseinrichtung eine bedeutend vereinfachten Aufbau einer derartigen Vorrichtung. Dazu werden mehrere Antriebsmittel, die sich im Randbereich des Substratträgers befinden, von der Regeleinrichtung derart zusammengeschaltet, dass sie wie ein einziges Antriebsmittel wirken. Als Sensor wird ein funktionales Element aus dem inneren Bereich gewählt. Bevorzugt wird ein funktionales Element verwendet, dessen Beitrag zur Erreichung einer Schmiegefläche am geringsten ist.

Sämtliche Angaben zu Wertebereichen in gegenständlicher Beschreibung sind so zu verstehen, dass diese beliebige und alle Teilbereiche daraus mit umfassen, z.B. ist die Angabe 1 bis 10 so zu verstehen, dass sämtliche Teilbereiche, ausgehend von der unteren Grenze 1 und der oberen Grenze 10 mitumfasst sind, d.h. sämtliche Teilbereich beginnen mit einer unteren Grenze von 1 oder größer und enden bei einer oberen Grenze von 10 oder weniger, z.B. 1 bis 1,7, oder 3,2 bis 8,1 oder 5,5 bis 10.

Die Ausführungsbeispiele zeigen mögliche Ausführungsvarianten des Substratträgers, wobei an dieser Stelle bemerkt sei, dass die Erfindung nicht auf die speziell dargestellten Ausführungsvarianten derselben eingeschränkt ist, sondern vielmehr auch diverse Kombinationen der einzelnen Ausführungsvarianten untereinander möglich sind und diese Variationsmöglichkeit aufgrund der Lehre zum technischen Handeln durch gegenständliche Erfindung im Können des auf diesem technischen Gebiet tätigen Fachmannes liegt. Es sind also auch sämtliche denkbaren Ausführungsvarianten, die durch Kombinationen einzelner Details der dargestellten und beschriebenen Ausführungsvariante möglich sind, vom Schutzumfang mit umfasst.
Der Ordnung halber sei abschließend darauf hingewiesen, dass zum besseren Verständnis des Aufbaus des Substratträgers diese bzw. deren Bestandteile teilweise unmaßstäblich und/oder vergrößert und/oder verkleinert dargestellt wurden.

Die den eigenständigen erfinderischen Lösungen zugrundeliegende Aufgabe kann der Beschreibung entnommen werden.

Vor allem können die einzelnen in den Fig. 1 bis 6 gezeigten Ausführungen den Gegenstand von eigenständigen, erfindungsgemäßen Lösungen bilden. Die diesbezüglichen, erfindungsgemäßen Aufgaben und Lösungen sind den Detailbeschreibungen dieser Figuren zu entnehmen.

### Bezugszeichenaufstellung

- 1: Substratträger
- 2: Trägerlage
- 3: Erste Flachseite
- 4: Funktionales Element
- 5: Antriebsmittel

- 6: Sensor
- 7: Zweite Flachseite
- 8: Haltemittel
- 9: Substrat
- 10: Imprint-Material

- 11: Kreisförmige Anordnung
- 12: Gitterartige Anordnung
- 13: Stempel
- 14: Mikro- bzw. Nanostruktur
- 15: Verfahrvorrichtung

- 16: Optische Aufnahmeeinrichtung
- 17: Regelungseinrichtung
- 18: Positioniervorrichtung
- 19: Stempelträger
- 20: Auflagefläche

- 21: Funktionale Elemente
- 22: Oberfläche / Fremdkörper
- 23: Antriebsmittel Phase 1
- 24: Sensor Phase 1
- 25: Deformation zum Zeitpunkt 1

- 26: Deformation zum Zeitpunkt 2
- 27: Deformation zum Zeitpunkt 3
- 28: Sensor Phase 2
- 29: Antriebsmittel Phase 2
- 30: Deformation zum Zeitpunkt 1'

## Patentansprüche

1. Substratträger (1) umfassend eine Trägerlage (2) und zumindest ein funktionales Element (4), **dadurch gekennzeichnet, dass** das funktionale Element als Antriebsmittel (5) ausgebildet ist.

2. Substratträger nach Anspruch 1, **dadurch gekennzeichnet, dass** das Antriebsmittel (5) aus einem piezoelektrischen Material gebildet ist.

3. Substratträger nach Anspruch 1 oder 2, **dadurch gekennzeichnet, dass** die Trägerlage (2) flächenhaft ausgebildet ist und eine erste (3) und zweite (7) Flachseite aufweist.

4. Substratträger nach Anspruch 3, **dadurch gekennzeichnet, dass** die zweite Flachseite (7) der Trägerlage (2) ein Haltemittel (8) zum lösbaren Halten eines flächenhaften Objekts, insbesondere eines Substrats (9), aufweist.

5. Substratträger nach Anspruch 4, **dadurch gekennzeichnet, dass** das Haltemittel (8) durch eine Unterdruckhaltevorrichtung gebildet ist.

6. Substratträger nach einem der Ansprüche 3 bis 5, **dadurch gekennzeichnet, dass** das Antriebsmittel (5) mit der ersten Flachseite (3) der Trägerlage (2) verbunden ist.

7. Substratträger nach Anspruch 6, **dadurch gekennzeichnet, dass** auf der ersten Flachseite (3) der Trägerlage (2) mehrere Antriebsmittel (5) angeordnet sind.

8. Substratträger nach Anspruch 7, **dadurch gekennzeichnet, dass** die Antriebsmittel (5) strukturiert angeordnet sind.

9. Substratträger nach einem der vorherigen Ansprüche, **dadurch gekennzeichnet, dass** zumindest ein Sensor (6) vorhanden ist.

10. Substratträger nach Anspruch 9, **dadurch gekennzeichnet, dass** der Sensor (6) aus einem piezoelektrischen Material gebildet ist.

11. Substratträger nach Anspruch 9 oder 10, **dadurch gekennzeichnet, dass** der Sensor (6) mit der ersten Flachseite (3) der Trägerlage (2) verbunden ist.

12. Substratträger nach einem der Ansprüche 9 bis 11, **dadurch gekennzeichnet, dass** auf der zweiten Flachseite (7) der Trägerlage (2) mehrere Sensoren (6) angeordnet sind.

13. Substratträger nach einem der Ansprüche 9 bis 12, **dadurch gekennzeichnet, dass** die Sensoren (6) strukturiert angeordnet sind.

14. Vorrichtung zur Formung von Mikro- bzw. Nanostrukturen auf einem Substrat (9), umfassend zumindest einen Substratträger (1), ein flächenhaftes Substrat (9) und einen Stempel (13), wobei zumindest auf einer Flachseite des flächenhaften Substrats (9) ein Imprint-Material (10) aufgetragen ist und das Substrat (9) vom Substratträger (1) derart gehalten wird, dass das Imprint-Material (10) einer Wirkfläche des Stempels zugewandt ist und wobei auf der Wirkfläche des Stempels ein mikro- bzw. nanostrukturiertes Abbild (14) der in das Imprint-Material (10) zu prägenden Struktur aufgebracht ist und wo der Stempel (13) in einer Verfahrvorrichtung (15) gehalten ist, **dadurch gekennzeichnet, dass** der Substratträger (1) gemäß den Ansprüchen 1 bis 13 ausgebildet ist.

15. Vorrichtung nach Anspruch 14, **dadurch gekennzeichnet, dass** der Stempel (13) aus einem für UV-Licht transparentem Material gebildet ist.

16. Vorrichtung nach Anspruch 14 oder 15, **dadurch gekennzeichnet, dass** eine optische Aufnahmeeinrichtung (16) vorhanden ist.

17. Vorrichtung nach einem der Ansprüche 14 bis 16, **dadurch gekennzeichnet, dass** eine Regelungseinrichtung (17) vorhanden ist.

18. Vorrichtung nach Anspruch 17, **dadurch gekennzeichnet, dass** die Regelungseinrichtung (17) zur gezielten Beeinflussung der Antriebsmittel (5) ausgebildet ist.

19. Vorrichtung nach Anspruch 17 oder 18, **dadurch gekennzeichnet, dass** die Regelungseinrichtung (17) zur Auswertung von der optischen Aufnahmeeinrichtung (16) bereitgestellten Bilder ausgebildet ist.

20. Vorrichtung nach Anspruch 17 bis 19, **dadurch gekennzeichnet, dass** die Regelungseinrichtung (17) zur Auswertung von den Sensoren (6) ermittelten Prozessgrößen ausgebildet ist.

21. Vorrichtung nach einem der Ansprüche 14 bis 19, **dadurch gekennzeichnet, dass** die Verfahrvorrichtung (15) zur Bewegung des Stempels (13) in Richtung parallel zur Ebene der Trägerlage (2) ausgebildet ist.

22. Imprint Lithographie Verfahren zur Formung von Mikro- bzw. Nanostrukturen auf einem Substrat (9), **dadurch gekennzeichnet, dass** eine Vorrichtung gemäß den Ansprüchen 14 bis 19 verwendet wird.

23. Imprint Lithographie Verfahren nach Anspruch 22, **dadurch gekennzeichnet, dass** bei einer Krafteinwirkung normal zur Flachseite der Trägerlage (2), vom Sensor (6) eine Spannung abgegeben wird.

24. Imprint Lithographie Verfahren nach Anspruch 22 oder 23, **dadurch gekennzeichnet, dass** vom Antriebsmittel (5) die Trägerlage (2) in Richtung normal zu ihrer Auflagefläche verformt wird.

25. Imprint Lithographie Verfahren nach einem der Ansprüche 22 bis 24, **dadurch gekennzeichnet, dass** vom Antriebsmittel (5) die Trägerlage (2) in der Ebene parallel zu ihrer Auflagefläche bewegt wird.

26. Imprint Lithographie Verfahren nach einem der Ansprüche 22 bis 25, **dadurch gekennzeichnet, dass** von der Regelungseinrichtung (17) die Antriebsmittel (5) selektiv gesteuert werden.

27. Imprint Lithographie Verfahren nach einem der Ansprüche 22 bis 26, **dadurch gekennzeichnet, dass** der Substratträger (1) wellenförmig verformt wird.

28. Imprint Lithographie Verfahren nach einem der Ansprüche 22 bis 27, **dadurch gekennzeichnet, dass** der Substratträger (1) zu Mikroschwingungen angeregt wird.
